# EUROPEAN PATENT APPLICATION

(11) **EP 4 793 224 A1**
(43) Date of publication of application: **19.08.2026**
(21) Application number: 25158199.7
(22) Date of filing: 17.02.2025
(51) Int. Cl.: B81B 7/02

(54) **MICROELECTROMECHANICAL SYSTEM**

(71) Applicant: Murata Manufacturing Co., Ltd., Nagaokakyo-shi, Kyoto 617-8555 (JP)
(72) Inventor: IIHOLA, Antti, 00950 Helsinki (FI); LIUKKU, Matti, 00320 Helsinki (FI)
(74) Representative: Boco IP Oy Ab

(57) **Abstract**

The disclosure relates to a microelectromechanical system comprising an ASIC layer, an interposer layer, a MEMS layer with movable structures and a cap layer stacked with each other in a listed order. The interposer layer and the cap layer form one isolated enclosure, and the ASIC layer and the cap layer form another isolated enclosure, wherein pressures in the isolated enclosures are different. An advantage of the arrangement of the disclosure is that it allows to set different pressures in the isolated enclosures reliably without extra process steps.

## Description

### FIELD OF THE DISCLOSURE

The present disclosure relates to a microelectromechanical system, and particularly to system with isolated enclosures having different pressures inside. The disclosure also relates to a fabrication method of the microelectromechanical system.

### BACKGROUND OF THE DISCLOSURE

Microelectromechanical (MEMS) devices, such as for measuring acceleration, rotation rate, magnetic field, pressure and/or combination of those, commonly comprise a MEMS wafer, where the movable transducer structure is located, and an ASIC wafer, designed to evaluate the measured signal from the MEMS wafer. To minimize the design space of the MEMS device, the ASIC wafer can be integrated with the MEMS wafer structures vertically.

Frequently, the MEMS structure comprises two moving structure which have different functionality, thus requiring different surrounding pressures for proper operation. For example, the MEMS system may combine a gyroscope, which requires a low pressure for its operation, and an accelerometer, which may function at an ambient pressure. Publication US20120326248A1 discloses a MEMS structure with two enclosures having different gas pressures inside and the ways to fabricate such structure. However, in US20120326248A1 extra design space and complex fabrication process steps are required for setting different pressures in the enclosures, which unnecessary complicate the process and can lead to undesired pressure irregularities. Therefore, the MEMS structure which allows to set different pressure in the enclosures reliably and efficiently is desired.

### BRIEF DESCRIPTION OF THE DISCLOSURE

An object of the present disclosure is to provide a MEMS system so as to solve the above problem.

The object of the disclosure is achieved by a MEMS system which is characterized by what is stated in the independent claims. Some embodiments of the disclosure are disclosed in the dependent claims.

The disclosure is based on the idea of the MEMS system comprising an ASIC layer, an interposer layer, a MEMS layer and a cap layer attached one to another. The MEMS system further comprises two isolated enclosures formed between the ASIC layer and the cap layer, wherein two isolated enclosures each comprises one movable structure formed in the MEMS layer, and wherein two isolated enclosures have different pressures inside.

An advantage of the arrangement of the disclosure is that it allows to set different pressures in the isolated enclosures reliably.

### BRIEF DESCRIPTION OF THE DRAWINGS

In the following the disclosure will be described in greater detail by means of preferred embodiments with reference to the accompanying drawings, in which:
Figure 1 illustrates a MEMS structure of this disclosure;
Figure 2a illustrates an example of the MEMS system comprising a first measurement electrode;
Figure 2b illustrates an example of the MEMS system comprising the first measurement electrode and a second measurement electrode, as well as movement of a first movable structure;
Figure 3a illustrates an example of how an ASIC layer may be connected to the outside through an interposer layer, a device layer and a cap layer;
Figure 3b illustrates an example of how an ASIC layer may be connected to the outside using wire bonding;
Figure 4 illustrates a fabrication process of the MEMS system of this disclosure.

### DETAILED DESCRIPTION OF THE DISCLOSURE

The disclosure relates to a microelectromechanical (MEMS) system comprising an ASIC layer, wherein the ASIC layer comprises a control circuit, an interposer layer comprising a first side and a second side, wherein the ASIC layer is attached to the first side of the interposer layer, and a MEMS layer comprising a first side and a second side, wherein the second side of the interposer layer is attached to the first side of the MEMS layer, a cap layer attached to the second side of the MEMS layer, wherein the interposer layer and the cap layer form a first isolated enclosure with the MEMS layer inside, and the ASIC layer and the cap layer form a second isolated enclosure with the MEMS layer inside, wherein pressure in the first isolated enclosure is different from pressure in the second isolated enclosure, and wherein MEMS layer comprises a first movable structure and a second movable structure, and wherein the first movable structure is in the first isolated enclosure, and the second movable structure is in the second isolated enclosure.

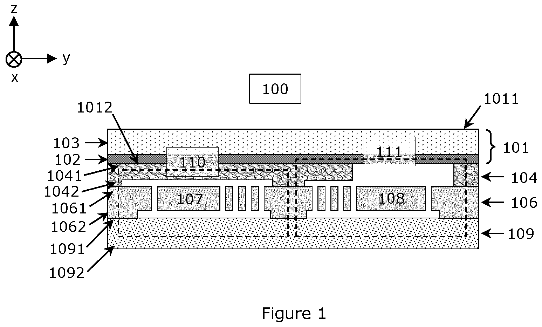

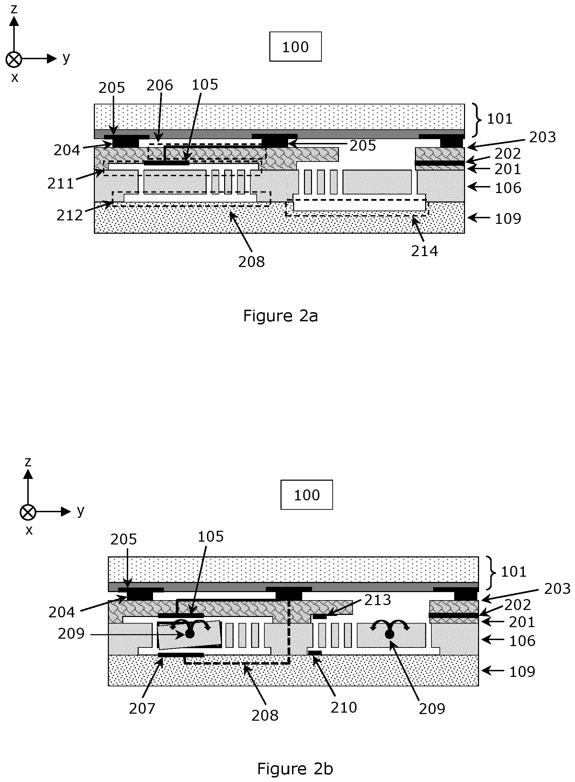

A microelectromechanical (MEMS) system 100 of this disclosure is illustrated in Figure 1. It comprises an ASIC layer 101. The ASIC layer comprises a control circuit 102. The ASIC layer 101 may comprise a first layer and a second layer attached one above the other. The first layer may be an ASIC substrate 103. The second layer may be the control circuit 102. The ASIC layer 101 may comprise a first side 1011 and a second side 1012. The first side 1011 may correspond to the ASIC substrate 103. The second side 1012 may correspond to the control circuit 102. The ASIC layer 101 may comprise ASIC conductive elements at the second side, such as 205 illustrated in Figure 2.

The MEMS system 100 further comprises an interposer layer 104. The interposer layer 104 comprises a first side 1041 and a second side 1042 opposite to each other. The second side of the ASIC layer 101 may be attached to the first side 1041 of the interposer layer 104. Specifically, the control circuit 102 of the ASIC layer 101 may be attached to the first side 1041 of the interposer layer 104. The ASIC layer 101 may be attached to the first side 1041 of the interposer layer 104 by means of bonding. Specifically, the ASIC layer 101 may be attached to the first side 1041 of the interposer layer 104 by means of metal bonding.

The interposer layer 104 may comprise a first insulating layer 201, as illustrated in Figure 2. The first insulating layer 201 may be attached to a MEMS layer underneath (disclosed below). The interposer layer 104 may further comprise a first conductive layer 202 on top of the first insulating layer 201. The interposer layer 104 may comprise a second insulating layer 203 on top of the first conductive layer 202. The interposer layer 104 may comprise more alternating insulating and conductive layers. The material of the insulating layers may be silicon oxide. The material of the conductive layers may be polysilicon. The material of the conductive layers may be metal. The layered structure of the interposer layer allows adding numerous routing paths for connecting the ASIC layer to the remaining parts of the MEMS system.

The interposer layer 104 may comprise interposer conductive elements at the first side, such as 204 and 214 illustrated in Figure 2. Some interposer conductive elements, such as 204, may be used to bond the interposer layer to the ASIC layer. Other interposer conductive elements, such as 214, may be used to route signals from the interposer layer to the ASIC layer.

The microelectromechanical system, wherein the interposer layer comprises a first measurement electrode at the second side, wherein the first measurement electrode is adjacent to the first movable structure in the first isolated enclosure.

The interposer layer 104 may comprise a first measurement electrode 105 at the second side 1042, as illustrated in Figure 2a. The material of the first measurement electrode 105 may be polysilicon. The structure of the MEMS system 100 allows to have a first measurement electrode 105 at the interposer layer 104 inside the MEMS system 100, which does not require any modification to the ASIC layer 101 and simplifies the fabrication process.

The interposer layer 104 may comprise an upper detection gap 211 formed by recessing the second side 1042.

The MEMS system 100 further comprises a MEMS layer 106. The MEMS layer 106 comprises a first side 1061 and a second side 1062. The second side of the interposer layer 104 is attached to the first side 1061 of the MEMS layer 106. The interposer layer 104 may be attached to the MEMS layer 109 by means of bonding. Alternatively, the interposer layer 104 may be deposited on the MEMS layer 104. In this case, the interposer layer 104 may be partly released from the MEMS layer 106 after deposition, so that the movable structures of the MEMS layer 106 can move.

The MEMS layer 106 may define a device plane. The device plane may also be called a horizontal plane or xy-plane. The direction which is perpendicular to the device plane may be called a vertical direction or a z-direction. Words such as "horizontal", "vertical", "bottom" and "top", "above" and "below" etc. do not in this disclosure refer to the orientation of the device with regard to the direction of earth's gravitational field either when the device is manufactured or when it is in use. Instead, the word "horizontal" simply defines a plane and "vertical" defines a direction which is perpendicular to that plane. The other terms then refer to relative positions in this "vertical" direction.

The MEMS layer 106 comprises a first movable structure 107 and a second movable structure 108. The MEMS layer 106 may comprise moving parts other than the first movable structure 107 and the second movable structure 108. Further, the MEMS layer 106 may comprise static parts (not marked in figures). The static parts always remain immobile in relation to the surrounding parts of the MEMS system 100. The first movable structure and the second movable structure may be attached to the static parts with flexible springs which allow the movable structures to move in relation to the static structure. The flexible springs may also be called suspenders. The static parts of the MEMS layer may define the device plane. Alternatively, the moving parts in non-actuates state may define the device plane.

The first movable structure 107 and the second movable structure 108 may be configured to move independently from each other.

The MEMS layer 106 may be formed by a silicon wafer. The silicon may be doped, and the MEMS layer 106 may in practice be electrically conductive.

The MEMS layer 106 may comprise a lower detection gap 212 formed by recessing the second side 1062. The recessing of 1062 may be carried out with many different etching methods. It may in some applications be particularly advantageous to perform the recessing in a local-oxidation-of-silicon (LOCOS) process. This allows the height of the lower gap to be controlled very accurately. The height of the upper detection gap 211 in the z-direction may be substantially equal to the height of the lower detection gap 212 in the z-direction.

The height of the upper and lower detection gaps 211-212 in the z-direction may be 0.9 - 3.0 um. The height of the upper and lower detection gaps 211-212 in the z-direction may be 1.4 - 2.4 um. The gap height tolerance may be less than +/-40 nm for both upper and lower detection gaps 211-212.

The MEMS layer 106 may comprise perforations (not illustrated in the figures). The perforations are a set of relatively small holes which extend through the MEMS layer 106 in the z-direction. The perforations facilitate easier access to the first insulating layer 201 through the MEMS layer 106 when first insulating layer 201 is removed during fabrication process. The perforations may be etched in the movable structure 107 or 108 (measurement region) in the MEMS layer 106, but they may alternatively be located elsewhere. The optimal locations and sizes of the perforations depend on the geometry of the device, on the thickness of the first insulating layer 201 and on the etching process with which the first insulating layer 201 is removed. The MEMS system 100 further comprises a cap layer 109. The cap layer 109 is attached to the second side 1062 of the MEMS layer 106. The cap layer 109 may comprise a first side 1091, which may be attached to the MEMS layer 106. The cap layer 109 may be attached to the MEMS layer 106 by means of bonding. The cap layer 109 may be attached to the MEMS layer 106 by means of anodic bonding. The cap layer 109 may comprise a second side 1092, which is opposite to the first side 1091.

The cap layer 109 may comprise a cap recess 214 in the first surface, as illustrated in Figure 2a. Specifically, the cap recess 214 may be in the second isolated enclosure 111. Depth of the cap recess in the z -direction may be 10-30 um. Specifically, depth of the cap recess in the z -direction may be more than 10 um or less than 30 um. The recess 214 may be particularly useful when the second movable structure 108 is part of the accelerometer structure to provide more space for the out-of-plane movement (discussed in detail later).

The ASIC layer 101, the interposer layer 104, the MEMS layer 106 and the cap layer 109 may be attached to one another in the vertical direction is the described order.

The interposer layer 104 and the cap layer 109 form a first isolated enclosure 110 with the MEMS layer 106 inside. The ASIC layer 101 and the cap layer 109 form a second isolated enclosure 111 with the MEMS layer 106 inside. In other words, one part of MEMS layer 106 may be in the first isolated enclosure 110, and another part of the MEMS layer may be in the second isolated enclosure 111. The term "isolated" may mean that the enclosure is hermetically sealed from the external environment and from another enclosure, if more than one is present.

Pressure in the first isolated enclosure 110 is different from pressure in the second isolated enclosure 111. The pressure in the first isolated enclosure 110 may be lower than in the second isolated enclosure 111. The fabrication process of the MEMS system (introduced below) allows providing different pressures in the first isolated enclosure and in the second isolated enclosure, which are crucial for the movable structures inside the isolated enclosures to operate correctly. In the fabrication process, pressure setting is reliable and efficient as it does not require any additional structural modifications in the MEMS system. The pressure is set when bonding the ASIC layer to the interposer layer (with, for example, metal bonding), and the cap layer to the MEMS layer (with, for example, anodic bonding).

Specifically, the pressure in the first isolated enclosure 110 may be a vacuum. The pressure in the first isolated enclosure 110 may be 0.4 - 1.1 mbar. The pressure in the second isolated enclosure 111 may be 1250 - 2000 mbar. The gas in the first isolated enclosure 110 and the second isolated enclosure 111 may be pure Argon. Other noble gases such as Neon and Helium may also be used. Nitrogen (N₂) may be used as well.

The first movable structure 107 may be in the first isolated enclosure 110. The second movable structure 108 may be in the second isolated enclosure 111. The first measurement electrode 105 may be in the first isolated enclosure 110. The first measurement electrode 105 may be adjacent to the first movable structure 107 in the z-direction. The first measurement electrode 105 may be connected to the interposer conductive element 214 in the interposer layer 104 by means of first measurement via, such as 206 illustrated in Figure 2a. The first measurement electrode 105 may be configured to measure out of the device plane displacement of the first movable structure 107. Specifically, the out of device plane displacement of the first movable structure 107 may be measured using capacitance change in the first measurement electrode 105. The first movable structure 107 may function as one of the electrodes of the capacitor, and the first measurement electrode 105 may be a first counter electrode of the capacitor.

The first movable structure 107 and the second movable structure 108 may be configured to move out of the device plane, as illustrated in Figure 2b. In Figure 2b, the first movable structure 107 is rotated out of the device plane, and the second movable structure 108 is in the device plane (not rotated). Specifically, the first movable structure 107 and/or the second movable structure 108 may be configured to rotate around a first rotation axis. The first rotation axis may lie in the device plane. The first rotation axis may be along the x-direction and pass through the point 209 as illustrated in Figure 2b. Alternatively, the first movable structure 107 and/or the second movable structure 108 may be configured to perform linear translation in the z-direction (not illustrated).

The benefit of having the interposer layer 104 between the ASIC layer 101 and MEMS layer 106 is that it provides a design freedom for the movable structures 107 and 108 and the first measurement electrode 105 arrangement with excellent electrical performance. The interposer layer 104 provides low parasitic capacitances and built-in bias environment for sensitive signal detection. Without the interposer layer 104, the out-of-plane detection would need to take place against the second surface of the ASIC layer 101, which is difficult and expensive as it requires to accommodate large and electrically undisturbed detection electrodes on the second surface of the ASIC layer 101.

The microelectromechanical system of claim 1, wherein the cap layer comprises a first side, which is attached to the MEMS layer, and the cap layer also comprises a second measurement electrode at the first side, wherein the second measurement electrode is adjacent to the first movable structure in the first isolated enclosure.

The microelectromechanical system of any of the preceding claims, wherein the first measurement electrode is polysilicon.

The microelectromechanical system of any of the preceding claims, wherein the first measurement electrode and/or the second measurement electrode are metal.

The cap layer 109 may comprise a second measurement electrode 207 at its first side 1091, as illustrated in Figure 1. The second measurement electrode 207 may be in the first isolated enclosure 110. The second measurement electrode 207 may be adjacent to the first movable structure 107 in the z-direction. The second measurement electrode 207 may be connected to the ASIC layer 101 by means of second measurement via, such as 208 in Figure 2.

The second measurement electrode 207 may be configured to measure out of the device plane displacement of the first movable structure 107. In other words, both the first measurement electrode 105 and the second measurement electrode 207 may be configured to measure out of device plane displacement of the first movable structure 107 in the first isolated enclosure 110. Specifically, the out of device plane displacement of the first movable structure 107 may be measured using capacitance change in the first measurement electrode 105 and the second measurement electrode 207. Specifically, the first movable structure may comprise a first measurement region facing the first measurement electrode 105, and a second measurement region facing the second measurement electrode 207. The first and the second measurement regions may be aligned one above the other along the z-direction. The first measurement region of the first movable structure 107 (e.g. made of single crystal silicon) may function as a first electrode of a capacitor, the first measurement electrode 105 may be a first counter electrode of the capacitor. The second measurement region of the first movable structure 107 may function as a second electrode of the capacitor and the second measurement electrode 207 may be a second counter electrode of the capacitor.

The benefit of using the aligned first and second measurement regions of same first movable structure 107 is that this facilitates a differential measurement. A capacitance measured across the first measurement gap to the first measurement electrode 105 may be labelled C1, and a capacitance measured across the second measurement gap to second measurement electrode 207 may be labelled C2. When the first and second measurement regions are the aligned one on top of the other, movement of the first movable structure 107 in the positive z-direction (upward in figures) decreases C1 and increases C2, while movement in the negative z-direction (downward) increases C1 and decreases C2. The differential capacitance DC = C1 - C2 will typically exhibit a more linear dependence on mass displacement than either of the two capacitances individually.

Primarily, the measurement gaps and the measurement electrodes may be used for out-of-plane displacement detection, as discussed above. However, the measurement gaps and the measurement electrodes may also be utilized for actuation of the movable structures.

The material of the first measurement electrode 105 may be polysilicon. The material of the first measurement electrode 105 and the second measurement electrode 207 may be metal. Specifically, the material of the second measurement electrode 207 may be aluminum. The thickness of the aluminum second measurement electrode 207 may be 80 nm. The aluminum second measurement electrode 207 may further comprise a 50 nm layer of insulating Diamond Like Carbon (DLC) on top of it.

The microelectromechanical system of any of the preceding claims, wherein the ASIC layer is electrically connected to the cap layer by means of ASIC vias in the interposer layer and the MEMS layer, and signals from the ASIC layer are routed outside of the MEMS system from the cap layer.

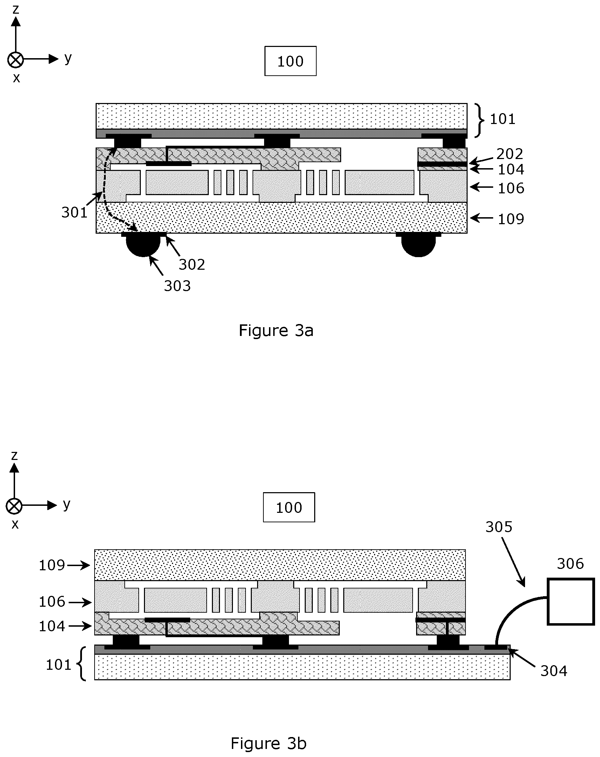

Figure 3a illustrates an example of how the signals from the MEMS system 100 may be routed to the outside. In this example, the ASIC layer 101 may be electrically connected to the cap layer 109 by means of ASIC vias such as, for example, ASIC TSVs, schematically illustrated as 301 in Figure 3a. The ASIC vias 301 may be arranged through the interposer layer 104 and the MEMS layer 106 to the cap layer 109.

The cap layer 109 may be made of silicon, and it may be doped so that it is electrically conductive. The cap layer 109 may comprise a first vertical contacts (not illustrated), which extend from the first side 1091 to the second side 1092. The first vertical contacts may be electrically isolated from other parts of the cap layer by insulating cap regions. The first vertical contact may be connected to the output contact pads, such as 302.

The ASIC vias 301 may be terminated at the output contact pads 302 on the second side of the cap layer 109. The output contact pads 302 may be electrically connected to the outside of the MEMS system 100. For example, the cap layer 109 may comprise electrically conductive solder balls 303 at the second side 1092 which may be connected to the external printed circuit board (PCB, not illustrated). The MEMS system 100 may comprise numerous arrangements comprising ASIC vias, such as 301, output contact pads, such as 302, and electrically conductive solder balls, such as 303.

The benefit of this arrangement is that lateral space in the design of the MEMS system is reduced since all electrical connections are arranged vertically.

The microelectromechanical system of any of claims 1-4, wherein signals from the ASIC layer outside of the MEMS system are configured to be routed directly from the ASIC layer.

The microelectromechanical system of claim 6, wherein the signals from the ASIC layer to outside of the MEMS system are configured to be routed through a wire connected to the ASIC layer.

Alternatively, the signals may be directly routed from the ASIC layer 101 to the outside of the MEMS system 100, as illustrated in Figure 3b. Specifically, the ASIC layer 101 may comprise an output electrode 304 at the second side 1012. The output electrode 304 may be electrically connected to the outside electronics 306 by means of, for example, wire bonding 305. In this arrangement, the cap layer 109 may be passive and comprise no electrically conductive elements. Alternatively, the cap layer 109 may comprise electrically conductive elements (not illustrated in Figure 3b), which are electrically connected to the MEMS layer 106, interposer layer 104 and/or ASIC layer 101, but not directly electrically connected to the outside of the MEMS system 100.

The benefit of this arrangement is that the fabrication process of the MEMS system is simplified since less vias for internal signal routes are required. Another benefit of routing the signals directly from the ASIC layer by wire bonding is that there is less mechanical stresses generated onto MEMS structure due to lack of solder ball assembly on the external printed circuit board.

The first movable structure may be a gyroscope.

A gyroscope is a device used to detect and measure changes in angular velocity and orientation of an object. Traditional MEMS gyroscopes contain a mobile proof mass, such as the first movable structure 107 in Figure 1, which usually comprises a part of a silicon wafer. The mobile proof mass is suspended from a fixed element, which is usually a fixed part of the same wafer. The proof mass is connected to force transducers which drive the proof mass into oscillating motion. When the gyroscope is subjected to angular rotation, the Coriolis effect causes the oscillation of the mobile proof mass to be modulated. This modulation of oscillation is directly proportional to the angular rate of the gyroscope and the magnitude of the angular rotation rate can be determined.

When the first movable structure is a gyroscope, the first and the second measurement electrodes may be used for quadrature signal compensation by applying a corresponding voltage to adjust the unwanted direction of movement of the movable structure.

The second movable structure may be an accelerometer.

An accelerometer is a device used to detect and measure the magnitude of the acceleration of an object. In a traditional MEMS accelerometer, a mass element, such as the second movable structure 108 in Figure 1, is suspended from a fixed structure with flexible suspension springs. When an external force acts on the accelerometer so that it accelerates, the mass element is displaced from its rest position. By measuring the magnitude of this displacement with a force transducer, the magnitude of the acceleration can be determined. An accelerometer should ideally not give any output signal when it is experiencing steady-state motion.

The pressure in the first isolated enclosure 110, where the gyroscope may be, may be lower than in the second isolated enclosure 111, where the accelerometer may be. Specifically, the pressure in the first isolated enclosure 110 may be a vacuum.

The second isolated enclosure 111 may comprise a first bump 210 as illustrated in Figure 2b. The first bump 210 may be at the first side 1091 of the cap layer 109. The purpose of the first bump 210 may be to mechanically stop the motion of the second movable structure 108 in the second isolated enclosure 111 before the capacitor is electrically short-circuited. The first bump 210 may be especially beneficial if the second isolated enclosure 111 comprises the accelerometer. Another purpose of the first bump 210 is to prevent MEMS layer 106 from bonding with cap layer 109 structures during anodic bonding. During the anodic bonding of the cap layer 109 to MEMS layer 106, the cap layer 109, which may be alkaline glass, is biased to high voltage while MEMS layer 106 silicon remains in grounded potential. This potential difference causes a strong electrostatic field pulling all movable structures of the MEMS layer 106 towards the cap layer 109. The first bump 210 at the cap layer 109, which may be composed of silicon dioxide covered with DLC, may prevent the permanent bonding of MEMS layer 106 structures to the cap layer 109. The final purpose of the first bump 210 may be electrical testing. The second movable structure 108 may undergo a pull-in test (against the stopper bumps) during the final probing, enabling the characterization of various functional properties of MEMS gyroscope and/or MEMS accelerometer.

The interposer layer 104 may comprise a second bump 213 on the 1042 side, as illustrated in Figure 2b. The second bump has same purpose as described above with respect to the first bump 210, expect for the stiction prevention since on the interposer layer may be bonded to the ASIC layer side with non-biased metal bonding.

Material of the second bump on the interposer layer 104 may be polysilicon. The second bump may be manufactured during the formation of the first measurement electrode 105.

### Fabrication method

A method of fabricating a microelectromechanical system of any of the preceding claims, comprising steps of a) forming an interposer layer on top of a first wafer, b) forming a MEMS layer from the first wafer, the MEMS layer comprising a first movable structure and a second movable structure, c) attaching a cap layer to the MEMS layer, so that a first isolated enclosure is formed between the cap layer and the interposer layer, and setting pressure in the first isolated enclosure, d) removing the part of the interposer layer over the second movable structure, e) attaching an ASIC layer to the interposer layer, so that a second isolated enclosure is formed between the ASIC layer and the cap layer, and setting pressure in the second isolated enclosure.

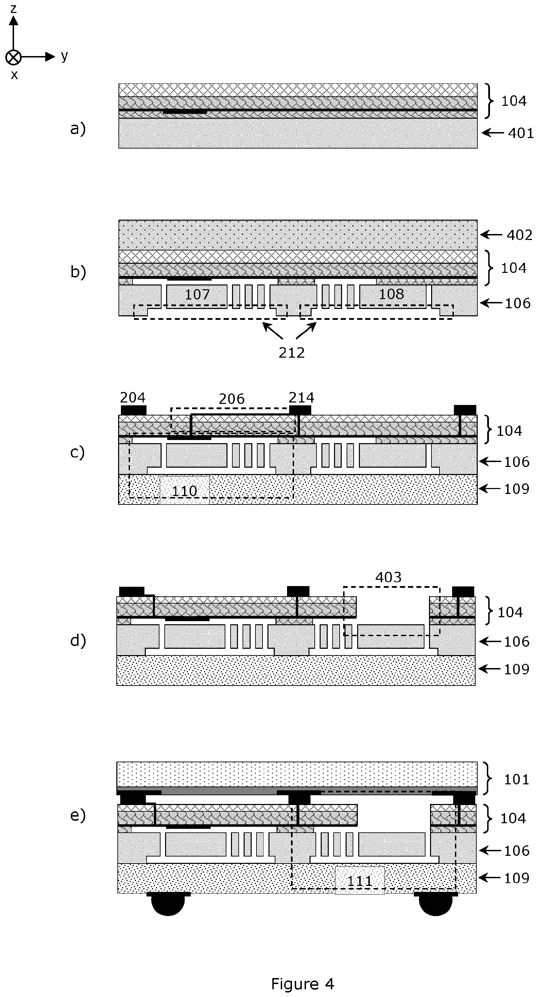

The MEMS system may be fabricated according to the following process, illustrated in Figure 4:
- Step a:
   ∘ Taking a silicon wafer 401 and exposing it to thermal oxidation to obtain a first oxide layer of certain thickness. Using lithography and dry etching to form recesses in/through the first oxide layer.
   ∘ Depositing a first conductive layer (for example polycrystalline silicon) on top of the first oxide layer. Using lithography and dry etching to obtain a first conductive pattern in the first conductive layer.
   ∘ Forming a second oxide layer over the first conductive pattern and the exposed first oxide layer. The first oxide layer, the first conductive layer and the second oxide layer forms an interposer layer 104 of the MEMS system.
   ∘ Optionally, depositing a thick third oxide layer over the second oxide layer.
- Step b:
   ∘ Attaching a temporary silicon carrier wafer 402 to the third oxide layer, by means of, for example, fusion bonding.
   ∘ Forming structures of a MEMS layer 106 in the silicon wafer 401 using, for example, first local oxidation of silicon (LOCOS) process to define a MEMS layer recess (detection gap 212), and second lithography and HF etching process to define the first and the second movable structures 107-108.
- Step c:
   ∘ Attaching a cap layer 109 to the MEMS layer by means of, for example, anodic bonding. Other attachment methods are also possible. Setting pressure in a first isolated enclosure 110 at this step. Pressure may be set by performing the bonding at a desired pressure.
   ∘ Removing the temporary silicon carrier wafer 402 and forming conductive vias, such as 206, through the third (optional) and the second oxide layers.
   ∘ Depositing metal layer, for example, titanium and germanium layer, over the third oxide layer, and patterning it using lithography and wet etching, to form metal contacts 204.
- Step d:
   ∘ Removing the first, the second, the third oxide layer and the first conductive layer over part 403 of the MEMS layer.
- Step e:
   ∘ Attaching an ASIC layer 101 to the metal contacts 204 by means of, for example, metal bonding. Setting pressure in a second isolated enclosure 111 at this step. Pressure may be set by performing the bonding at a desired pressure.
   ∘ Optionally, providing electrical contacts in the cap layer for external connection.

The disclosed fabrication method relates to the fabrication of MEMS systems wherein multiple systems are simultaneously manufactured from stacked wafers through wafer-level processing. After completing the fabrication steps, the wafers are diced to produce individual MEMS systems.

## Claims

1. A microelectromechanical system comprising:
- an ASIC layer, wherein the ASIC layer comprises a control circuit,
- an interposer layer comprising a first side and a second side, wherein the ASIC layer is attached to the first side of the interposer layer, and
- a MEMS layer comprising a first side and a second side, wherein the second side of the interposer layer is attached to the first side of the MEMS layer,
- a cap layer attached to the second side of the MEMS layer,
wherein
- the interposer layer and the cap layer form a first isolated enclosure with the MEMS layer inside, and the ASIC layer and the cap layer form a second isolated enclosure with the MEMS layer inside, wherein pressure in the first isolated enclosure is different from pressure in the second isolated enclosure,
- and wherein MEMS layer comprises a first movable structure and a second movable structure, and wherein the first movable structure is in the first isolated enclosure, and the second movable structure is in the second isolated enclosure.

2. The microelectromechanical system of claim 1, wherein the interposer layer comprises a first measurement electrode at the second side, wherein the first measurement electrode is adjacent to the first movable structure in the first isolated enclosure.

3. The microelectromechanical system of claim 1 or 2, wherein the cap layer comprises a first side, which is attached to the MEMS layer, and the cap layer comprises a second measurement electrode at the first side, wherein the second measurement electrode is adjacent to the first movable structure in the first isolated enclosure.

4. The microelectromechanical system of any of the preceding claims, wherein the first measurement electrode is polysilicon.

5. The microelectromechanical system according to any of claims 1-3, wherein the first measurement electrode and/or the second measurement electrode are metal.

6. The microelectromechanical system of any of the preceding claims, wherein the ASIC layer is electrically connected to the cap layer by means of ASIC vias in the interposer layer and the MEMS layer, and signals from the ASIC layer are routed outside of the microelectromechanical system from the cap layer.

7. The microelectromechanical system of any of claims 1-5, wherein signals from the ASIC layer outside of the microelectromechanical system are configured to be routed directly from the ASIC layer.

8. The microelectromechanical system of claim 7, wherein the signals from the ASIC layer to outside of the microelectromechanical system are configured to be routed through a wire connected to the ASIC layer.

9. The microelectromechanical system of any of the preceding claims, wherein the first movable structure is a gyroscope, and the second movable structure is an accelerometer.

10. A method of fabricating a microelectromechanical system of any of the preceding claims, comprising steps of:
a) forming an interposer layer on top of a first wafer,
b) forming a MEMS layer from the first wafer, the MEMS layer comprising a first movable structure and a second movable structu re,
c) attaching a cap layer to the MEMS layer, so that a first isolated enclosure is formed between the cap layer and the interposer layer, and setting pressure in the first isolated enclosure,
d) removing the part of the interposer layer over the second movable structu re,
e) attaching an ASIC layer to the interposer layer, so that a second isolated enclosure is formed between the ASIC layer and the cap layer and setting pressure in the second isolated enclosure.
